# EUROPÄISCHE PATENTANMELDUNG

(11) **EP 1 936 808 A2**
(43) Veröffentlichungstag der Anmeldung: **25.06.2008**
(21) Anmeldenummer: 07024876.0
(22) Anmeldetag: 21.12.2007
(51) Int. Cl.: H03K 19/0175

(54) **Eingangsstufe für eine Treiberschaltung eines leistungselektronischen Bauteils**

(30) Priorität: 23.12.2006 DE 102006061496
(71) Anmelder: SEMIKRON Elektronik GmbH & Co. KG, 90431 Nürnberg (DE)
(72) Erfinder: Königsmann, Gunter, 91058 Erlangen (DE); Bode, Rüdiger, 90763 Fürth (DE); Obernöder, Daniel, 97346 Iphofen (DE); Mühlhöfer, Alexander, 90522 Oberasbach (DE)

(57) **Zusammenfassung**

Eine Eingangsstufe für eine Treiberschaltung eines leistungselektronischen Bauteils, mit zwei differentiellen Steuereingängen und einem Signalausgang enthält einen, einen invertierenden und einen nichtinvertierenden Verstärkereingang und einen zum Signalausgang führenden Verstärkerausgang aufweisenden Differenzverstärker, und ein zwischen den Steuereingängen und den Verstärkereingängen angeschlossenes, an einer Versorgungsspannung betreibbares Netzwerk, wobei das Netzwerk zwei bezüglich der Steuereingänge und der Verstärkereingänge topologisch symmetrische Teilnetze enthält, und jedes Teilnetz ohmsche Widerstände zur Pegelanpassung der Steuereingänge an die Verstärkereingänge enthält.

## Beschreibung

Die Erfindung betrifft eine Eingangsstufe für eine Treiberschaltung eines leistungselektronischen Bauteils.

Leistungselektronische Bauteile sind in diesem Zusammenhang z.B. Leistungshalbleiterschalter, welche heute in der Regel modular aufgebaut sind, d.h. über das eigentliche Leistungsschaltelement und einen diesem vorgeschalteten Treiber verfügen. Der Treiber setzt hierbei ein in der Regel schwachpegeliges Steuersignal z.B. ein TTL-Signal, in ein Leistungsschaltsignal um, welches dann den eigentlichen Schaltvorgang des Leistungsschaltelements bewirkt.

Derartige Treiber bzw. Treiberschaltungen weisen wiederum mehrere Schaltungsteile auf, von welchen einer die sogenannte Eingangsstufe ist. Die Eingangsstufe stellt die vom Benutzer des leistungselektronischen Bauteils anzusteuernde Schnittstelle dar.

Zur Zeit existieren grob etwa folgende Klassen von Eingangsstufen bzw. digitalen Eingängen:

Massebezogene Eingänge besitzen eine begrenzte Geschwindigkeit. Ihre Störsicherheit kann nur durch hohe Signalspannungen erreicht werden, wobei die Anzahl von Herstellern, welche CMOS-Bausteine für hohe Signalspannungen anbieten, kontinuierlich sinkt. Die hohen Spannungen zum Ansteuern der Eingänge bzw. der Logik müssen vom Kunden, also dem letztendlichen Benutzer der Eingangsstufe ausschließlich für diesen einen Zweck zur Verfügung gestellt werden. Zur Erreichung von Störsicherheit werden zusätzlich hohe Filterkapazitäten am Eingang benötigt, was zu einer zusätzlichen Durchlaufzeit führt und durch die Variation der Kapazitäten (± 10-20% für einen Kondensator eine Parallelisierung von Treibern bzw. Eingangsstufen, d.h. deren gemeinsame parallele Ansteuerung, erschwert. Alternativ ließe sich Störsicherheit durch eine Supressordiode erreichen, welche sicherer ist und einen trade-off zwischen Kapazität und Preis bietet, jedoch generell einen höheren Preis aufweist.

Immer mehr moderne bzw. schnelle CMOS-Schaltkreise besitzen eine Grenze für die maximal zugelassene Anstiegszeit für Signale an deren Eingängen, da im Zuge der Geschwindigkeitsoptimierung Querströme im Bereich zwischen den Schwellenspannungen zweier Eingangstransistoren, die eine CMOS Eingangsschaltungbilden, stark erhöht wurden.

Alternativ existieren differentielle digitale Eingänge, wie z.B. LVDS, PECL oder Gunning-Logik. Diese sind im Automotive-Bereich weit verbreitet und in vielen Logikbausteinen, auch programmierbarer Logik, bereits fertig integriert. Derartige Eingänge sind optimiert für extrem hohe Schaltgeschwindigkeiten, welche niedrige Signalspannungen zur Folge haben, um den Energieverbrauch pro Schaltvorgang gering zu halten. Sie weisen hohe, jedoch begrenzte Störsicherheit auf. Aufgrund der niedrigen maximalen Eingangsspannung verfügen sie über einen begrenzten Gleichtakteingangsspannungsbereich. Zwischen einer z.B. vom Benutzer bereits verfügbaren Standardlogik und einem differentiellen Eingang ist in der Regel ein Vermittler, d.h. Transceiver notwendig. Eine aus zwei bis drei Widerständen bestehende Anpassungsschaltung ist ebenfalls möglich, welche jedoch die positiven Eigenschaften der differentiellen Schnittstelle wieder verringert.

Des Weiteren existieren paketbasierte Schnittstellen, wie z.B. CAN, Firewire oder Ethernet. Diese sind jedoch teuer bzw. oft mit Lizenzgebühren belastet. Durch die Paketorientierung müssen die Schaltvorgänge entweder synchron zum Pakettakt geschehen oder werden mit einem starken Jitter belastet. Außerdem sind sie nicht kompatibel zu diskret aufgebauten Schaltungen auf Kundenseite, d.h. der Kunde, also letztendliche Benutzer der Eingangsstufe, benötigt Know-How zur Herstellung eines Transceivers. Ziel bei der Entwicklung von Eingangsstufen ist daher, dass diese mit den bereits beim Kunden vorhanden Logikpegeln kompatibel sind, z.B. einen 5V-Ausgang zur Ansteuerung bzw. Weiterverarbeitung im Treiber bereitstellen und dass entsprechende Treiberleistungen erreichbar sind, was eine Erhöhung der Störsicherheit erfordert.

Aufgabe der vorliegenden Erfindung ist es daher, eine verbesserte Eingangstufe für eine Treiberschaltung eines leistungselektronischen Bauteils anzugeben.

Die Aufgabe der Erfindung wird gelöst durch eine Eingangsstufe für eine Treiberschaltung eines leistungselektronischen Bauteils, wobei die Eingangsstufe zwei differentielle Steuereingänge und einen Signalausgang aufweist. Über die differentiellen Steuereingänge ist die Eingangsstufe später von einem Benutzer, z.B. dem Kunden des Herstellers der Eingangsstufe, ansteuerbar. Der Signalausgang stellt das eigentliche Schaltsignal für die Treiberschaltung zur Verfügung. Die erfindungsgemäße Eingangsstufe enthält einen Differenzverstärker, welcher einen invertierenden und einen nichtinvertierenden Verstärkereingang und einen zum Signalausgang führenden Verstärkerausgang aufweist. Weiterhin ist zwischen den Steuereingängen und Verstärkereingängen ein Netzwerk angeschlossen, welches an einer Versorgungsspannung betreibbar ist. Das Netzwerk weist zwei bezüglich der Steuereingänge und der Verstärkereingänge topologisch symmetrische Teilnetze auf und jedes Teilnetz enthält ohmsche Widerstände zur Pegelanpassung der Steuereingänge an die Verstärkereingänge. Die topologische Symmetrie bezieht sich darauf, dass das Netzwerk zwischen erstem Steuereingang und erstem Verstärkereingang topologisch symmetrisch zu demjenigen ist, welches zwischen zweitem Steuereingang und zweitem Verstärkereingang zu finden ist.

Durch den differentiellen Eingang ist die erfindungsgemäße Eingangsstufe weitestgehend störsicher. Durch Verwendung eines einfachen oder z.B. im Treiber ohnehin vorhandenen Differenzverstärkers ist die Eingangsstufe auch kostengünstig. Trotz eines ESD-Schutzes ist die Eingangsstufe bei Weglassen der digitalen Filterung extrem schnell. Dies bietet die Möglichkeit, den Steuereingang nach einer einfachen Reprogrammierung mit einem Hochgeschwindigkeitsdatenbus zu verbinden. Der Hochgeschwindigkeitsdatenbus sendet dann die digitalen Schaltsignale über eine räumliche Entfernung an die einzelnen Treiber eines z.B. verteilten Umrichters, also mehrerer leistungselektronischer Bauteile, die von einer einzigen Treiberschaltung angesteuert sind. Die Eingangsstufe kann mit herkömmlicher Schaltungstechnik auch als massebezogener nicht- oder invertierender Eingang verwendet werden. Durch einen einfachen Spannungsteiler ist die Eingangsstufe an bestehende, z.B. massebezogene Low-Cost-Schnittstellen anpassbar. Die Eingangsstufe ist auch als differentielle Schnittstelle verwendbar.

Beide Eingänge der Eingangsstufe sind senderseitig niederimpedant abgeschlossen, z.B. der nichtinvertierende Eingang durch den Sender des Kunden und der invertierende Eingang durch einen Kondensator. Empfängerseitig sind generell beide Eingänge der Eingangsstufe aufgrund des symmetrischen Aufbaus der Teilnetze im Netzwerk mit der selben Impedanz abgeschlossen.

Werden die topologisch symmetrischen Teilnetze hinsichtlich ihrer Bauteildimensionen leicht asymmetrisch ausgeführt, ist es möglich, der Eingangsstufe bzw. dem Differenzverstärker eine Vorzugsrichtung zuzuweisen, d.h. bei Nichtbeschaltung beider Steuereingänge ergibt der Signalausgang einen vorgebbaren Wert.

Jedes Teilnetz kann zwei ohmsch gekoppelte ohmsche Spannungsteiler enthalten, wobei der erste Spannungsteiler im Ruhezustand die Mittenspannung der Steuereingänge und der zweite Spannungsteiler im Ruhezustand die Mittenspannung der Verstärkereingänge aufweist. Somit findet eine rein ohmsche Pegelanpassung der Steuereingänge an die Verstärkereingänge statt.

Hierzu kann jedes Teilnetz einen endseitig mit der Versorgungsspannung (in der Regel +V_{cc} und Masse) verbindbaren Längszweig aufweisen, der drei in Reihe geschaltete ohmsche Widerstände enthält. Zwischen erstem und zweitem Widerstand entsteht so ein erster Knoten, welcher über einen vierten ohmschen Widerstand mit einem Steuereingang verbunden ist, zwischen zweitem und drittem Widerstand entsteht ein zweiter Knoten, welcher an je einen Verstärkereingang angeschlossen ist. Eine derartige Eingangsstufe ist dann auf viele verschiedene Arten und Weisen betreibbar. So kann eine derartige Eingangsstufe als massebezogener Eingang betrieben werden, wenn einer der Steuereingänge mit der Versorgungsspannung (bzw. Masse) verbunden ist. Die Versorgungsspannung bietet so die Referenz für einen der Eingänge, der andere ist dann auf die Versorgungsspannung bezogen. Durch die Wahl des einen oder anderen Steuereingangs als Signaleingang kann die Eingangsstufe wahlweise als invertierender oder nichtinvertierender Versorgungsspannungsbezogener Eingang verwendet werden.

Insbesondere kann in diesem Fall der Steuereingang über die Reihenschaltung eines ohmschen Widerstandes und eines Kondensators an der Versorgungsspannung angeschlossen sein. Insbesondere können in diesem Fall mehrere gleiche Eingangsstufen jeweils miteinander verbunden werden, und zwar an demjenigen Anschluss des Kondensators, welcher der Versorgungsspannung gegenüber liegt. Insbesondere müssen dann die weiteren Eingangstufen keinen eigenen Kondensator aufweisen, sondern können den Kondensator der einen Eingangsstufe gemeinsam mitbenutzen.

Natürlich kann die Eingangsstufe ohne Zusatzbeschaltung als differentieller Empfänger bzw. differentielle Eingangsstufe betrieben werden, wobei durch die Eingangsstufe lediglich eine Pegelanpassung erfolgt.

Der Signalausgang des Differenzverstärkers kann ein nichtinvertierender bzw. invertierender Signalausgang sein und der Differenzverstärker einen entsprechend entgegengesetzten zusätzlichen Signalausgang aufweisen. Beispielsweise kann dann der nichtinvertierende Signalausgang über einen ersten ohmschen Widerstand mit einem der Steuereingänge und der invertierende Signalausgang über einen zweiten ohmschen Widerstand mit dem korrespondierenden Verstärkereingang verbunden sein. Der Eingangsstufe wird so eine Hysterese hinzugefügt.

Eine entsprechende Eingangsstufe ist in der Regel für den Einsatz in Verbindung mit programmierbarer Logik gedacht. Ein derartiger Logikbaustein weist in der Regel eine größere Anzahl von Ein- und Ausgängen auf, als in der jeweiligen Anwendung benötigt. Die restlichen, in der speziellen Anwendung nicht benutzten Ein- und Ausgänge können so zusätzlich für die Eingangsstufe benutzt werden. Zur Einführung der Hysterese sind daher lediglich zwei zusätzliche ohmsche Widerstände notwendig. Der eine Widerstand koppelt das Ausgangsignal des Differenzverstärkers in dessen Eingang zurück und der zweite Widerstand kompensiert die Auswirkungen dieser Rückkopplung nach außen, d.h. zum Steuereingang hin.

Insbesondere kann der Differenzverstärker ein LVDS-Empfänger sein.

Eine Anpassung an eine beliebige höhere Eingangsspannung, kann durch einen bekannterweise vor den Steuereingang geschalteten ohmschen Spannungsteiler erfolgen. Durch diesen kann so beispielsweise ein + 5V Eingangsignal auf den Eingangsspannungsbereich eines LVDS-Empfängers abgebildet werden, welcher es differentiell auswertet.

Für eine weitere Beschreibung der Erfindung wird auf die Ausführungsbeispiele der Zeichnungen verwiesen. Es zeigen, jeweils in einer schematischen Prinzipskizze:
- Fig. 1: eine erfindungsgemäße Eingangsstufe in ihrer Grundstruktur als differentiellen Eingang,
- Fig. 2: die Eingangsstufe aus Fig. 1 im Betrieb als nichtinvertierender bzw. invertierender Eingang,
- Fig. 3: die Verschaltung mehrere Eingangsstufen als massebezogener Eingang und als a) nichtinvertierender und b) invertierender Eingang,
- Fig. 4: die Eingangsstufe aus Fig. 1 mit einer Hystereseschaltung.

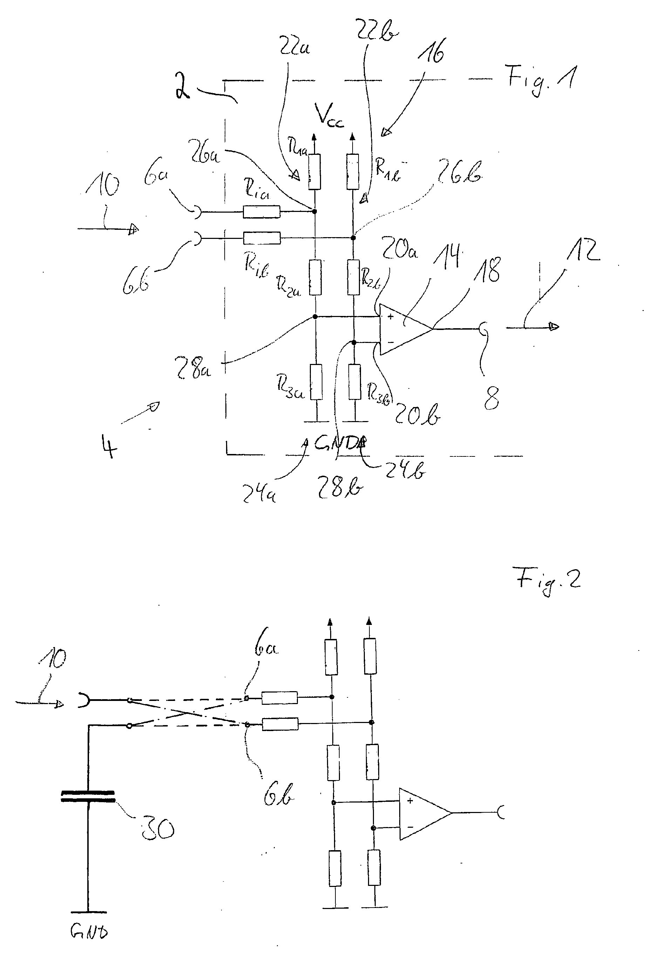

Fig. 1 zeigt eine Eingangsstufe 2 eines Treibers 4 eines nicht dargestellten Leistungshalbleiterschalters. Die Eingangsstufe 2 weist zwei differentielle Steuereingänge 6a,b und einen Signalausgang 8 auf. Die Steuereingänge 6a,b sind von außerhalb des Treibers 4 zugänglich, so dass ein nicht dargestellter Benutzer des Treibers 4, z.B. Kunde der den Treiber 4 bzw. den Leistungshalbleiterschalter herstellenden Firma diesen ansteuern kann.

Der Signalausgang 8 ist im Inneren des Treibers 4 an der weiteren, nicht dargestellten Ansteuerelektronik des Leistungsschalters angeschlossen und übermittelt an diese ein Schaltsignal 12. Über die Steuereingänge 6a,b wird dem Treiber 4 ein Steuersignal 10 zugeführt.

Die Eingangsstufe 2 umfasst weiterhin einen Differenzverstärker 14, im Beispiel einen LVDS-Komparator und ein ohmsches Widerstandsnetzwerk 16, welches die Steuereingänge 6a,b mit dem Differenzverstärker 14 verbindet. Der Differenzverstärker 14 weist einen Ausgang 18, welcher auf den Signalausgang 8 geführt ist, sowie einen nichtinvertierenden Eingang 20a und einen invertierenden Eingang 20b auf.

Das Widerstandsnetzwerk 16 weist zwei Teilnetze 22a,b auf, wobei das Teilnetz 22a den nichtinvertierenden Steuereingang 6a mit dem nichtinvertierenden Eingang 20a und das Teilnetz 20b den invertierenden Steuereingang 6b mit dem invertierenden Eingang 20b verbindet.

Das Teilnetz 22a weist einen Längszweig 24a mit einer Serienschaltung aus drei Widerständen R₁ₐ, R₂ₐ und R₃ₐ auf, wobei das eine Ende des Widerstandes R₁ₐ an eine Versorgungsspannung V_{cc} und das eine Ende des Widerstandes 3a an eine Masse GND angeschlossen ist. Die jeweils anderen Enden der betreffenden Widerstände sind mit je einem Knoten 26a und 28a verbunden, zwischen welchen wiederum der Widerstand R₂ₐ liegt. Der Knoten 26a ist über einen Widerstand Rᵢₐ mit dem nichtinvertierenden Steuereingang 6a verbunden, der Knoten 28a mit dem nichtinvertierenden Eingang 20a.

Der Widerstandsteiler R₁ₐ zu R₂ₐ + R₃ₐ erzeugt hierbei aus der Versorgungsspannung V_{cc} am Knoten 26a und damit am nichtinvertierenden Steuereingang 6a eine Referenzspannung, welche in der Mitte des Eingangsbereichs des Treibers 4 bzw. der Eingangsstufe 2 liegt. Der Spannungsteiler R₁ₐ + R₂ₐ zu R₃ₐ dagegen erzeugt aus der Versorgungsspannung V_{cc} eine Referenzspannung in der Mitte des Referenzbereichs des Differenzverstärkers 14. Durch diese beiden, ohmsch gekoppelten Spannungsteiler wird also der Eingangsbereich der gesamten Eingangsstufe 2 auf den Gleichtakteingangsspannungsbereich des Referenzverstärkers 14 abgebildet.

Sämtliche Ausführungen für das Teilnetz 22a gelten entsprechend für das Teilnetz 22b. Die Teilnetze 22a,b sind also bezüglich ihrer Netzwerktopologie identisch bzw. symmetrisch.

Für die Bauteildimensionierung für die verschiedenen Widerstände gibt es nun im Wesentlichen zwei Alternativen. Die einzelnen Widerstände der Teilnetze 22a, b welche einander entsprechen, also z.B. die Widerstände R₁ₐ und R_{1b} können gleich ausgeführt sein. Im Ruhezustand bzw. nicht beschalteten Zustand der Eingangsstufe 2, wenn also die Steuereingänge 6a,b z.B. offen, also im Leerlauf sind, entstehend dann an den Eingängen 20a,b des Differenzverstärkers 14 nahezu identische Spannungen, weshalb dessen Signalausgang 8 undefiniert ist.

Um dies zu vermeiden, können daher einander entsprechende Widerstände der Teilnetze 22a,b leicht unterschiedlich ausgeführt sein, so dass im oben genannten Fall an den Eingängen 20a,b leicht unterschiedliche Spannungen anliegen. Der Signalausgang 8 befindet sich dann in einem je nach Dimensionierung der Widerstände gewünschten Signalzustand, z.B. HIGH oder LOW. Die Eingangsstufe 2, der Treiber 4 und damit das der Leistungsschalter gehen so in einem Zustand offener Steuereingänge 6a,b in einen sicheren Zustand des Ausgangssignals 12 und damit sicheren Schaltzustand. Die gesamte Schaltung wird fehlersicher für offene Eingänge.

In Fig. 1 wird die Eingangsstufe 2 in der Regel differentiell angesteuert, d.h. das Steuersignal 10 wird gegentaktig auf die Steuereingänge 6a,b geführt.

Fig. 2 zeigt eine alternative Ansteuerung der Eingangsstufe 2 aus Fig. 1, bei der (gestrichelte Linie) nur der nichtinvertierte Steuereingang 6a oder (strichpunktierte Linie) der invertierende Steuereingang 6b als Eingang für das Steuersignal 10 benutzt wird. Der jeweils andere Steuereingang ist über einen Kondensator 30 zur Masse GND geführt. So arbeitet die Eingangsstufe 2 aus Fig. 1 in der Beschaltung gemäß Fig. 2 als nichtinvertierender (gestrichelt) oder invertierender (strichpunktiert) Eingang.

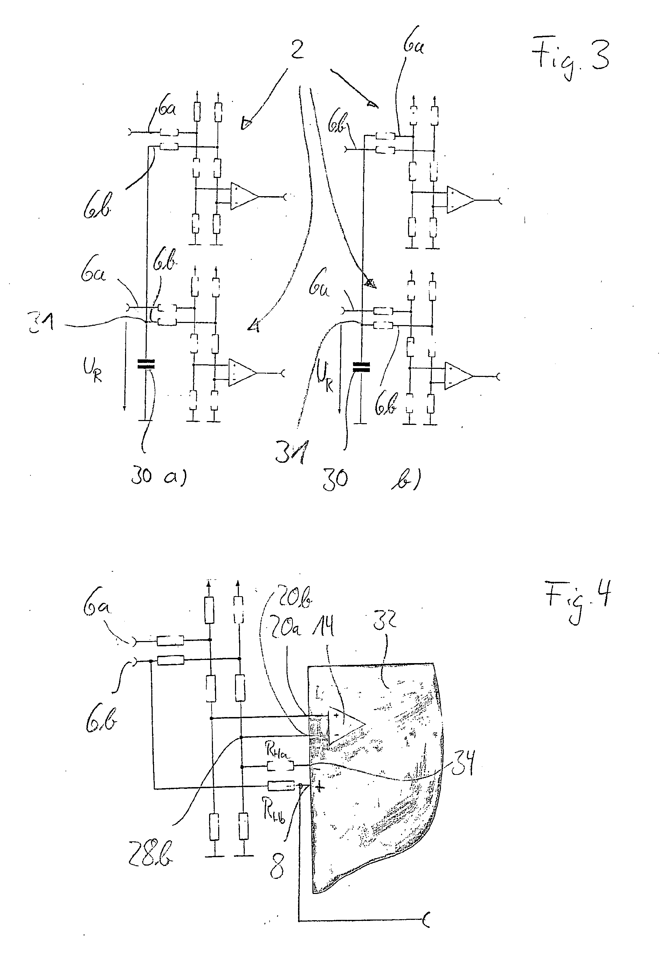

Fig. 3 zeigt bei einer derartigen Verwendung der Eingangsstufe 2 zwei weitere Verwendungsvarianten, bei der jeweils zwei identische Eingangsstufen 2 parallel geschaltet sind. In Fig. 3a sind beide Eingangsstufen 2 gemäß der gestrichelten Ausführung aus Fig. 2 ausgeführt, d.h. als nichtinvertierende Eingangsstufen 2. Daher sind beide invertierenden Steuereingänge 6b auf einen einzigen gemeinsamen Kondensator 30 bzw. dessen gemeinsamen Knoten 31 geschaltet. Die Eingangsstufen 2 lassen sich also leicht parallelisieren. Für beide Steuereingänge 6a der Eingangsstufen 2 gilt somit die gleiche Gleichtaktreferenzspannung U_{R}, z.B. 2,5V bei einer Betriebsspannung V_{cc} von 5V.

In Fig. 3b ist der jeweils andere Steuereingang 6a,b der Eingangsstufen 2 auf den gemeinsamen Knoten 31 des Kondensators 30 geführt, so dass sich für die in Fig. 3 obere Eingangsstufe 2 der Steuereingang 6b als invertierender Steuereingang und für die untere Eingangsstufe 2 nach wie vor der nichtinvertierende Steuereingang 6a als Signaleingang darstellen. Auch hier ist, wie oben beschrieben, der Kondensator 30 gemeinsam benutzt und für beide Steuereingänge 6a,b die gleiche Referenzspannung U_{R} gültig.

Fig. 4 zeigt schließlich, dass der verwendete Differenzverstärker 14 Teil eines Logikbausteins 32 ist. Dieser stellt neben dem (nichtinvertierenden) Signalausgang 8 einen zusätzlichen invertierenden Signalausgang 34 zur Verfügung, der dem Signalausgang 8 gegentaktig zugeschaltet ist. Zur Realisierung eines Hystereseverhaltens der Eingangsstufe 2 ist in Fig. 4 der Signalausgang 8 über einen Widerstand R_{Hb} mit dem invertierenden Steuereingang 6b verbunden. Der invertierende Signalausgang 34 ist über einen entsprechenden Widerstand R_{Ha} mit dem Knoten 28b verbunden. So wird der Signalausgang 8 auf den Steuereingang 6b rückgekoppelt und gleichzeitig die Auswirkung dieser Rückkopplung nach außen, d.h. bezüglich des Steuereingangs 6b kompensiert.

### Bezugszeichenliste

- 2: Eingangsstufe
- 4: Treiber
- 6a,b: nicht-, invertierender Steuereingang
- 8: Signalausgang
- 10: Steuersignal
- 12: Ausgangssignal
- 14: Differenzverstärker
- 16: Widerstandsnetzwerk
- 18: Ausgang
- 20a,b: nicht-, invertierender Eingang
- 22a,b: Teilnetz
- 24a,b: Längszweig
- 26a,b: Knoten
- 28a,b: Knoten
- 30: Kondensator
- 31: gemeinsamer Knoten
- 32: Logikbaustein
- 34: invertierender Signalausgang

- R_{1-3,i/a,b}: Widerstand
- R_{Ha,b}: Widerstand
- V_{cc}: Versorgungsspannung
- GND: Masse
- U_{R}: Referenzspannung

## Patentansprüche

1. Eingangsstufe (2) für eine Treiberschaltung (4) eines leistungselektronischen Bauteils, mit zwei differentiellen Steuereingängen (6a,b) und einem Signalausgang (8),
- mit einem, einen invertierenden (20b) und einen nichtinvertierenden Verstärkereingang (20a) und einen zum Signalausgang (8) führenden Verstärkerausgang (18) aufweisenden Differenzverstärker (14),
- und mit einem zwischen den Steuereingängen (6a,b) und den Verstärkereingängen (20a,b) angeschlossenen, an einer Versorgungsspannung (V_{cc}, GND) betreibbaren Netzwerk (16), wobei das Netzwerk (16) zwei bezüglich der Steuereingänge (6a,b) und der Verstärkereingänge (20a,b) topologisch symmetrische Teilnetze (22a,b) enthält, und jedes Teilnetz (22a,b) ohmsche Widerstände (R_{1-3,i,a-b}) zur Pegelanpassung der Steuereingänge (6a,b) an die Verstärkereingänge (20a,b) enthält.

2. Eingangsstufe (2) nach Anspruch 1, bei der jedes Teilnetz (22a,b) zwei ohmsch gekoppelte ohmsche Spannungsteiler (R₁+R/R₃,R₁/R₂+R₃) enthält, wobei der erste Spannungsteiler (R₁/R₂-R₃) im Ruhezustand die Mittenspannung der Steuereingänge (6a,b) aufweist und der zweite Spannungsteiler (R₁+R₂/R₃) im Ruhezustand die Mittenspannung der Verstärkereingänge (20a,b) aufweist.

3. Eingangsstufe (2) nach Anspruch 2, bei der jedes Teilnetz (22a,b) einen endseitig mit der Versorgungsspannung (V_{cc},GND) verbindbaren Längszweig (24a,b) aufweist, der drei in Reihe geschaltete ohmsche Widerstände (R_{1-3,a-b}) enthält, wobei je ein erster Knoten (26a,b) zwischen erstem und zweitem Widerstand (R_{2a,b}) über einen vierten ohmschen Widerstand (R_{ia,b}) mit je einem Steuereingang (6a,b) verbunden ist und je ein zweiter Knoten (28a,b) zwischen zweitem (R_{2a,b}) und drittem Widerstand (R_{3a,b}) an je einen Verstärkereingang angeschlossen ist.

4. Eingangsstufe (2) nach einem der vorhergehenden Ansprüche, bei der einer der Steuereingänge (6a,b) mit der Versorgungsspannung (V_{cc},GND) verbunden ist.

5. Eingangsstufe (2) nach Anspruch 4, bei der der Steuereingang über ein kapazitives Bauelement (30), insbesondere einen Kondensator, an der Versorgungsspannung (V_{CC},GND) angeschlossen ist.

6. Eingangsstufe (2) nach Anspruch 5, bei der das kapazitive Bauelement (30) mit seinem einen Ende an der Versorgungsspannung (V_{cc}, GND) angeschlossen ist, und an dessen anderem Ende einen Anschluss (31) für weitere Eingangsstufen (2), insbesondere ohne kapazitives Bauelement (30), aufweist.

7. Eingangsstufe (2) nach einem der vorhergehenden Ansprüche, bei der der Signalausgang (8) ein nicht- oder invertierender Signalausgang (8) ist, mit einem zusätzlichen invertierenden oder nichtinvertierenden Signalausgang (34), wobei der nicht- oder invertierende Signalausgang (8) über einen ersten ohmschen Widerstand (R_{Hb}) mit einem der Steuereingänge (6a,b), und der invertierende oder nichtinvertierende Signalausgang (34) über einen zweiten ohmschen Widerstand (R_{Ha}) mit dem korrespondierenden Verstärkereingang (20a,b) verbunden ist.

8. Eingangsstufe (2) nach einem der vorhergehenden Ansprüche, bei der der Differenzverstärker (14) ein LVDS-Empfänger ist.
